# EUROPEAN PATENT SPECIFICATION

(11) **EP 1 127 387 B1**
(45) Date of publication and mention of the grant of the patent: **10.01.2007**
(21) Application number: 99945538.9
(22) Date of filing: 07.09.1999
(51) Int. Cl.: H01R 9/00, H05K 1/02

(54) **NON-CIRCULAR MICRO-VIA**
NICHTZIRKULÄRE MIKRO-BOHRUNG
MICROTRAVERSEES NON CIRCULAIRES

(30) Priority: 10.09.1998 US 99730 P
(43) Date of publication of application: 29.08.2001
(73) Proprietor: Viasystems Group, Inc., St. Louis, MO 63105 (US)
(72) Inventor: COTTON, Martin, A., South Shields, Tyne & Wear NE33 5BU (GB)
(74) Representative: Granleese, Rhian Jane
(86) International application number: PCT/US1999/020418
(87) International publication number: WO 2000/016443

(56) References cited:
- WO-A-98/06243
- FR-A- 2 040 016
- US-A- 5 347 086
- US-A- 5 414 222
- US-A- 5 426 399
- US-A- 5 442 144
- US-A- 5 522 132
- US-A- 5 719 750
- US-A- 5 724 727
- US-A- 5 734 560

## Description

### Technical Field

This invention relates to Printed Circuit Boards (PCBs) and particularly to micro-via plated through hole interconnect and shielding structures for PCBs and the method for creating such micro-vias and shielding structures.

### Background Art

It is always the goal in PCB design to increase the functionality and component capacity. Almost since the inception of PCB's, engineers have striven to add more and more functionality and hence more interconnect traces. These traces go from side to side and from layer to layer and in this way form the interconnect between the "active" electronic elements. The PCB has throughout its lifetime been made from many alternate materials and processes. The most common material being a glass epoxy based laminate, with the PCB builds being of a single sided, double sided or a multilayered (more than 2 layers) configuration. The interconnect medium between layers are created by drilling with mechanical drill through the layers of the PCB exposing the copper interconnect lands on the individual layers. The PCB is then passed through a plating solution and the various layers are connected by plated or deposited copper formed on the interior surface of the drilled through hole. This drilled plated barrel of inter layer interconnect is called a "via". The most obvious physical attribute is that the via is round when viewed from the top or bottom side. This is caused by "drilling". Drilling holes through laminate causes a round or circular hole to be created. Drilling of holes is carried out on a drilling machine that drills using a "drill", a mechanical device that rotates or cuts around its centerline cutting away material about the centerline to create the round or circular holes. The action of a drill is one of cutting.

As mentioned previously more and more interconnect traces have been required as circuit and hence PCB complexity increased. This of course has led to a decrease in size of the vias and an increase in their number. The new smaller vias are called "micro vias" and are typically of a blind nature. Blind vias are vias that do not pass completely through the PCB, but stop at some predetermined layer depth. The smaller via size is required due to an increase in trace density which reduces the points on a given layer where a terminal interconnect land can be positioned such that it aligns with a land on another layer without interference with traces there between. If cross-sectional real estate that a via occupies is reduced, the ability to utilize a via is more likely. However, the decrease in via size has meant that the mechanical drilling of micro vias is almost commercially extinct. Several alternate processes have sprung up namely laser ablation and plasma ablation. Material ablation is an electrochemical reaction to either laser light pulsing or the plasma process. It is not a cutting action or process. However, ablation in like manner removes away material around a centerline.

Ablation emulates mechanical drilling by creating a basically circular hole whichever method is used. This ablated round hole is often described as "drilling" because of removal of material about a centerline, hence the term, Micro via drilling. This round hole has performance level based around the creation of a round or circular shape hole, namely, current carrying capacity, resistance and inductance. For example, a blind via has a lower inductance than a through hole because it has shorter length to the barrel of the via, but its current carrying capacity does not alter because the diameter and hence the circumference of the hole remains the same. Therefore, the current carrying capacity of a via is dependent on the circumferencial length and the conducting medium thickness at the point of interconnection between the trace land and the via.

There are several problems with the conventional circular profile micro-via. For example, when densely populated multi-layer PCBs are utilized there are an enormous amount of traces and interconnects. Circular vias may be a limiting feature if the via is to avoid traces or components when extending through multiple layers because of the cutting area required for a circular hole. Also, the current carrying capacity of circular vias are limited because current carrying capacity of a via is a factor of circumference and thickness of the plating applied to the inner wall. This factor also effects the ability to have multiple traces on a single layer to connect up to the same via because the distance between the contact points are too short thus exceeding the current carrying capacity of the via at those points or the interconnect density at a given land or PCB layer. Conventional standard circular profile micro vias also have a characteristic inductance property due to the spiral nature of the circular via which effects the electron flow through the via resulting in an inductance. The inductance characteristic tends to slow down signal speed and increase noise susceptibility.

Through holes that can possibly be categorized as a Micro-via have been utilized on non-organic silicone based semi-conductor devices to connect two conductive layers separated by an insulation layer where the insulation layer has a contact through hole which exposes a portion of the two conductive surfaces. This through hole embodiment is where one conductive layer continuously extends down through the through-hole thereby electrically connecting the two layers. The semi-conductor via technology has a different purpose and hence a different structure, however it is worth mentioning when discussing via technology (electrical interconnection utilizing a through hole) for completeness. With a semiconductor via the first conductive layer actually conforms to the walls of the through hole and continues over the exposed area of the second layer and in continuous contact with said second layer forming what may be described as a blind via. However the process of forming the via is different from a process where material is cut away about a centerline and there is no plating structure.

In this semi-conductor example the through-hole is filled with a continuation of a first conductive layer of the semi-conductor into the through hole. The through hole structure utilized for semiconductor designs differs from through holes or micro vias utilized for printed circuit boards. First, micro vias for printed circuit boards interconnect a plurality of circuit trace terminal lands or pads by transcending through and exposing them to an interior conductive plating, whereas the semiconductor through hole structure is that of a hole through an insulation layer that separates two layers of conductive media. The interconnection is established by continuously extending one conductive media layer through the through hole establishing contact with the second layer. Establishing a plurality of interconnections to a node created by a via is not the objective in the semiconductor environment as it is with printed circuit board vias.

The specific issue with regard to semi conductor vias is electrical failure of the via structure due to thermal and other stresses particularly in the area around the rim of the opening of the through hole. This is where the conductive media layer begins to extend through the through hole and failures occur because it is at this point that the media layer tends to be thinner. The problem is concentration of stresses in a small area. Whereas, with printed circuit boards the issue with vias is the density of the interconnections as it relates to current carrying capacity and better voltage drop.

US5414222 discloses a multilayer integrated circuit package, which has a plurality of layers of conducting leads and has solid metal vias which connect leads in a first layer to leads in a second layer. At least one of the vias has a cross section such that the via is much larger in a first direction than in a second direction generally perpendicular to the first direction.

### Disclosure of the Invention

It is in view of the above problems that the present invention was developed.

The invention thus has an object to provide additional current carrying capacity for a via and reduce its inductance characteristic. It is also object of this invention to provide vias that can physically avoid traces and components for densely populated multiple trace multi-layer boards. It is also an object of this invention to connect traces on two or more layers that are not vertically in line. It is also the object of this invention to reduce inductance of the via.

The invention satisfies the above objects by providing a non-circular via and a method for cutting away material about a centreline for a non-circular via for PCBs. The method of drilling the non-circular via will be by cutting or removing material away about a centreline with a process such as laser ablation or plasma ablation. This type of cutting away of material about a centreline is sometimes referred to as ablation of material as noted above and allows lateral movement to effect noncircular patterns. This invention utilizes this noncircular approach in three forms, convoluted circle or a square, an extended elongated via up to three times the diameter in depth and a trenched via. The convoluted circle or non-circular via is a Profile Power Micro-via.

The Profile via has any shape other than round or circular to create an increased length in circumference over a round or circular format. The Profile via can have a non-circular wave form shape centered on the circumference or pitch circle diameter or an irregular shape that is not based on the round or circular form. A Three Diameter via or a 1-3D via is a through hole having two component dimensions were one is the major dimension of 1-3D length and the other minor dimension is its breadth having a 1 D diameter. Finally, a micro milled trench forming a co-axialised structure is used for noise protection EMI protection and is typically elongated longer than 3 times the diameter of the standard circular Micro-via.

### Brief Description of the Drawings

The advantages of this invention will be better understood by referring to the accompanying drawing, in which **Fig. 1** shows a top view of a typical profile of power micro-via forming a cross along with a conventional via. **Fig. 2** shows the definition of the length and width of a via in a top exterior view using a cross or "+" shaped via. **Fig. 3** shows an alternate Profile-1 forming an elbow or "L" shaped via. **Fig. 4** shows an alternate Profile-2 forming a "U" shaped micro via. **Fig. 5** shows an alternate Profile-3 forming a double cross micro via that is not based on the round circular format or were the shape is not centered on the circumference or pitch of the circle diameter. **Fig. 6** shows an alternate Profile-4 forming an "E" shaped micro via that is not based on the round circular format or were the shape is not centered on the circumference or pitch of the circle diameter. **Fig. 7 and Fig. 8** shows the Manhattan Interconnect Strategy. **Fig. 9 and Fig. 10** shows an alternate guard trench. **Fig. 11 and Fig. 12** shows a double guard trench.

### Best Mode of Carrying Out the invention

The inventor has discovered that non-circular vias are feasible for printed circuit boards and are desirable for many reasons. For example a non-circular via can take on an "L" shaped cross section to connect two circuit trace lands or terminal pads on separate circuit board layers while avoiding traces within the region between the legs of the "L" shaped via on layers there between. Other non-circular vias may be used in different ways to adapt to the specific circuit trace layout. It is also desirable to design Vias that are non-circular but are of equivalent overall diameter to comparable standard circular vias because they require less cutting area. This is because, the circumference of a circle is less than some shapes with equivalent overall diameter. The increased circumference makes utilization of non-circular vias beneficial because the increased circumference of no-circular vias increases the current carrying capacity of the via.

In addition it is found that plated through hole methods can be adapted to be utilized to create a perimeter ground plane trench or an outer shield trench , by using a micro milled trench around the perimeter of a PCB or the perimeter surrounding a component or a set of components and can provide an adequate grounding path for ground traces on multiple layers of the PCB and for multiple components positioned at various locations on the PCB or can be utilized for EMI protection. This technique is useful to conform with the available space of densely populated PCBs and uniquely shaped PCBs. The plated trench can extend through several PCB layers and can follow along the board edge regardless of the shape of the board. The trench structure can also encircle a certain area of the printed circuit board for EMI protection of that specific area of the board or a specific component. The trench provides EMI protection because it creates a coaxialised track structure. If a single trench is used it forms a partial outer shield for the coaxialised structure. The partial outer shield of he coaxialised structure comprises the plating of the wall of the trench, the ground plane, and the plating lip that laterally extends from the rim about the opening of the trench. The plating wraps around the rim of the opening of the trench and laterally extends from the opening forming a lip. The coaxialised structure is completed by the circuit trace co-axially extending through the outer shield formed by the trench.

Current grounding schemes may dedicate entire layers to a grounding plane which unnecessarily increases the thickness and weight of the Board and such a grounding layer usually requires isolation on either side by insulation layers. Another method is to utilize a grounding strip or grounding bar bonded between layers of PCBs or Bonded to the edge of a PCB. This requires a much more difficult manufacturing process and the grounding strip is more difficult to make it accessible to all the circuit traces on all of the layers of the PCB.

In summary, alternative shape features will alter the performance of a micro via by increasing it over known shape (round) performance, for example convoluted or square shaped vias. Three ideas form the basis of what is collectively known as Micro Features, for this invention. These three ideas are categorized as Profile Power Micro via, 1 D-3D Vias and the Guard Trench and will now be discussed.

### Profile Power Micro via

The basic difference in performance for this alternate micro via, is that it has a greater current carrying capacity than the traditional round or circular micro via of equivalent maximum diametric dimension. As the current carrying capacity of any via is dependent on the circumference wall length and the conducting medium wall thickness, it follows that a larger via (hole) will have a larger or longer circumference than a smaller counterpart. It is therefore the conclusion that the larger circumference (assuming the same conductive medium thickness) will have a greater amount of conducting medium in which to carry current. Profile Power micro vias for the purposes of this patent application are vias that have a circumference or via edge that is longer or larger than can be obtained by using a "round or circular" shape of equivalent maximum diameter in the design, imaging or manufacturing of micro vias. When used for regular interconnect via creation the shape of the via has as its major dimension the equivalent diameter of the normal circular micro via.

When used for a pure "Power configuration" the normal via max dimension need not apply. In this way the vias can be used in all power and interconnect strategies in PCB design and manufacture. The following are a few examples of the usage of the vias in a power interconnect strategy unrestricted by size constraints.

The Profile Power micro via can be any via that has any shape other than round or circular to create the increased length in circumference over equal diameter circular vias. The shape can for example be star, cross, square or any irregular or convoluted shape that increases the length of the circumference over a round or circular format. In principle the Profile Power micro vias are based on a circular format in that they can have a wave form shape centered on the circumference or pitch circle diameter, however the power micro via can be an irregular shape that is not based on the round or circular format. That is, the shape of the micro-via cross section can have an irregular shape that is not based on a round circumferencial maximum diameter or circular form. The micro-via can also be a convoluted stepped square pattern.

Also, the non-circular shape can allow more.traces on a given layer to connect to a single via in order to connect to traces on other layers. This is possible due to increased current carrying capacity at a given layer because of the increased circumference thereby increasing the number of possible points of interconnection. In addition noncircular vias allow traces and components to be avoided more readily. Another important feature is removal of the inductance characteristic as seen with the standard circular profile via design by eliminating the coil aspect inherent with circular profile vias. Elimination of inductance results in faster signal performance for highspeed signals because the inductance characteristic of the standard circular profile vias has the tendency to slow down a signal. Also, better noise susceptibility performance results from a non-circular format.

### 1D-3D Vias

The 1 D-3D via is an alternate form of the power profile micro via. If the standard or normal "round" micro via is considered as a 1 D via or a via with a diameter of the ratio 1.0, then the vias mentioned here are all via configurations that use a single diameter as the base dimensioning for a via of two component dimensions. Referring to Figure - 2 one of the dimensions is the length 202 and the other is the breadth or width 200. The length can be in the X or Y orientation or any orientation on a two dimensional plane. The same applies for the breadth. Therefore, a via having a round or circular shape ratio of 1.0 : 1.0 is to be considered a normal micro via and is not subject to this patent application.

The benefits to the 1D - 3D shape via configuration are that it can be directional, using the breadth (the smaller dimension) as the limiting factor for interconnect density. The length is restricted to 3D or three times the length of the breadth for this patent application. Vias with a ratio of greater than 3D are considered as "Trenching" and is described in the next section. Use of the 2D and 3D vias being used in a Manhattan configuration is possible, refer to Figs - 7 and 8. This enables a via of sufficient size (current carrying capacity) to be placed within a circuit trace track without round pads. Round vias and hence round via pads are limiting factors in interconnect density in PCB design. If we can use this format in design to realize high density interconnect with the same or increased current carrying capacity as normal vias, then an advantage over normal micro via design and manufacture is attained. As a benefit to the manufacture of PCB's the following can be achieved at the photo resist stage. Photo resist requires a certain minimum area of resist to adhere to the copper surface. During the manufacture of micro via PCB's the small vias are imaged using a small area of resist. If we assume that normal micro vias have a ratio of 1.0 : 1.0, then we can assume that any via of a greater ratio than 1.0 in one of the two dimensions will have a greater area of photo resist to adhere to the copper or other conductive imageable medium, thereby improving yield.

### Trenching

The micro milled trenched is a third form for using the micro via concept of having a non-circular or round cross section. Trenching is a slot that is "micro milled" using plasma or laser processing or other method if removing away material about a centerline. This slot is greater in depth than one layer. Trenching is similar to the 1 D-3D via formats shown previously. The difference between 1D/3D vias and trenching is length, the vias with a larger ratio than 3.0 : 1.0 is for this patent called trenching. This does not mean that the two are not interchangeable. There will be instances where the trenching could possibly be smaller that a ratio of 3D, so this must be taken into consideration for this invention. Trenching can be used for EMC screening but this technique can be used for all known reference plane or screening techniques that control signal integrity in laminate interconnect solutions. This trenching can be used on the edge of PCB's or within the area of the PCB. Trenching can be used in all PCB or application specific module types. It offers significant signal performance increases, but at a potentially lower layer count and hence lower production costs.

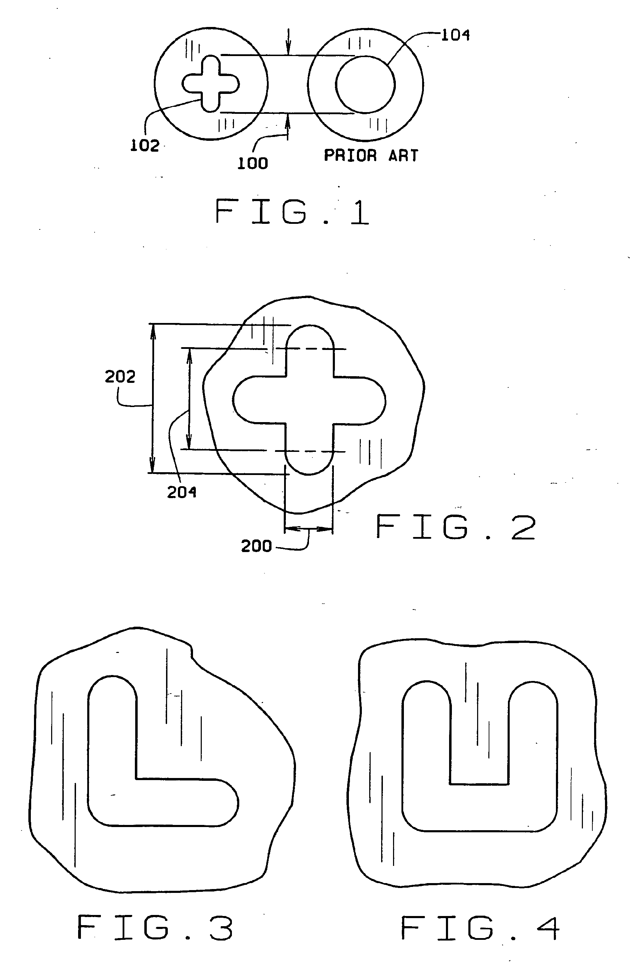

The premise and the details of the various aspects of the invention can be better understood by referring specifically to the drawing. First, referring to Fig. 1, a power profile non-circular cross section micro via 102 can be seen compared to a standard prior art round or circular cross section micro via 104. The maximum or major diameter 100 for the non-circular or "cross" shaped micro via is equivalent to the standard prior art circular via. This is descriptive of a non-circular micro via having a wave form shape centered on the circumference or pitch circle diameter. It can also be seen that the circumference of the "cross" or "+" shaped micro via is longer than the circumference of the standard circular shaped micro via thereby increasing the current carrying capacity of the via as previously explained. Referring to Fig. 2 the cross-shaped micro via is seen again. What is defined as the width 200 and the length 202 of the micro via is shown. The width 200 of the micro via is driven by the breadth of the cutting action of the cutting means and the length 202 of the micro via is driven by the translation distance of the cutting means. The second length 204 defined as the translation distance of the centerline of the cutting means about which it cuts.

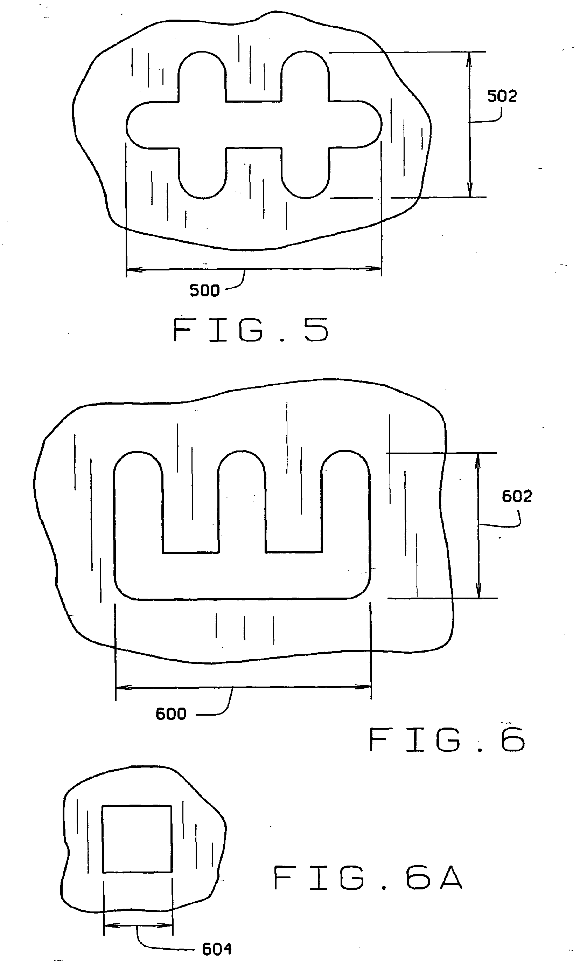

Referring to Figs. 3 and 4, an "L" shaped and a "U" shaped micro via are shown respectively. These alternative cross sections are also based on the round or circular format. However, referring to Figs. 5 and 6, a "double cross" or "++" and an "E" shaped micro via are shown respectively and they are not based on the round or circular format in that the have a major diameter, 500 and 600 respectively, and a smaller length minor diameter 502 and 602.

Finally, Fig. 6A shows a square micro via having a breadth 604 equivalent to the diameter of a standard circular profile micro via shown as major diameter 100 in Fig. 1.

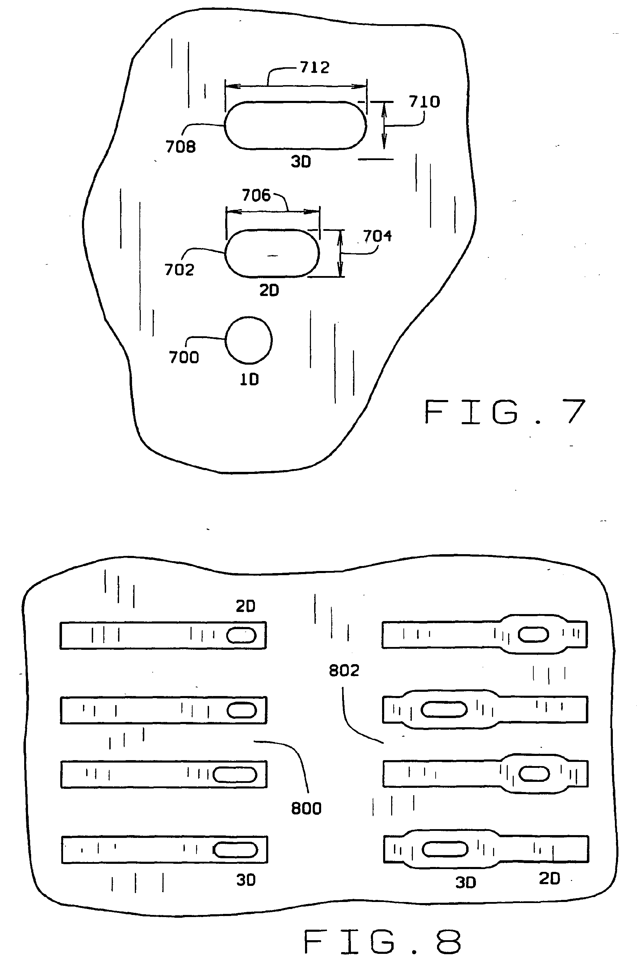

Referring to Fig. 7, the 1 D-3D micro via format as discussed earlier is shown. The 1 D micro via 700 is representative of a standard micro via having a circular cross section. The 2D micro via 702 has a minor diameter of breadth 704 and a greater length major diameter 706 where the major diameter is two times the diameter of the minor diameter. The 3D micro via 708 has a minor diameter 710 and a greater length major diameter 712 where the major diameter is three times the diameter of the minor diameter. A means of utilizing the 2D-3D micro via format can be seen by referring to Fig. 8 which shows the "Manhattan" (high density or high population) interconnect strategy 800. One of the benefits of 2D-3D shaped via is that it can be directional, using the breadth (the minor diameter) as the limiting factor for interconnect density. Utilizing the 2D-3D via as part of the Manhattan strategy enables a via of sufficient size (circumference or current carrying capacity) to be placed within a higher resolution (more closely spaced) circuit trace pattern without a round terminal pad or interconnect land. Round terminal pads and round vias can limit trace and interconnect density. If the Manhattan configuration is used in design to realize a higher density interconnect with the same or increased current carrying capacity, then an advantage over normal micro via design and manufacturer is attained. A second embodiment 802 of the Manhattan strategy 802 is shown where the circuit trace slightly widens to conform to the form of the via to allow greater current carrying capacity in the via.

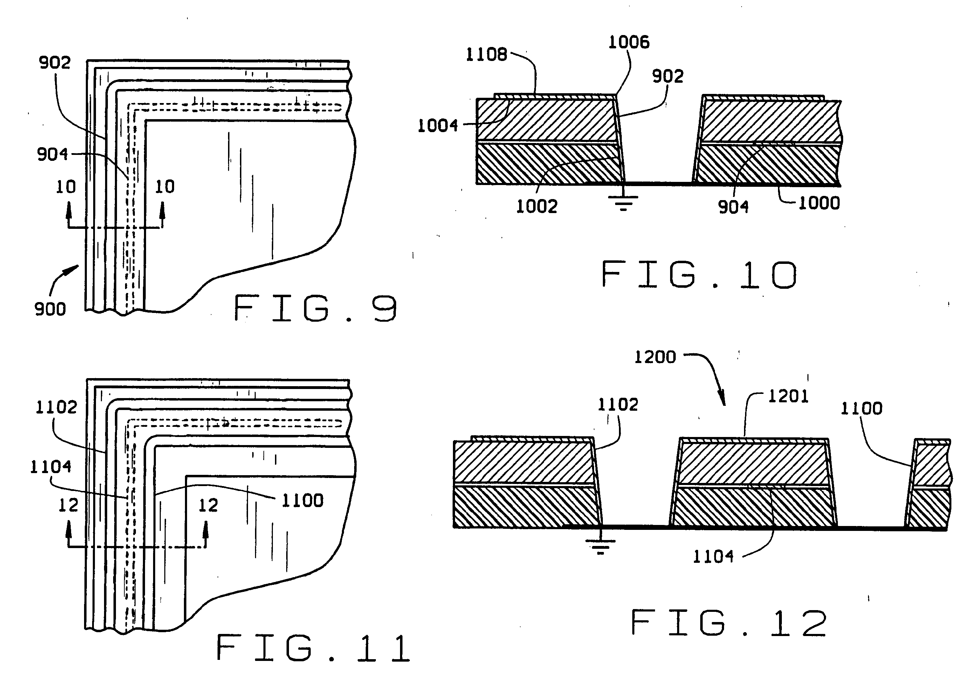

Referring to Figs. 9 - 11, a novel guard trenching method is shown. Fig. 9 shows a top view of a corner section of a printed circuit board 900 where a plated trench 902 is shown extended about the perimeter of the board. In this preferred embodiment the trenched via is actually one elongated trenched via aligned along the board edge, however the trench could be a series of aligned trench segments (not shown). Also this example shows an EMC sensitive track 904 (a circuit trace that may be EMI susceptible) that extends inside the perimeter and a partial outer shield defined by the trench and extends in parallel to said trench. The trace 904 is shown as segmented because it is hidden; however, the trace is continuous. This inner EMC sensitive track (EMI sensitive circuit trace) completes a coaxial shielding scheme as well as the possibility of a grounding path established by the plated trench. The plated trench via is created by milling a series of elongated trenched through holes along the desired perimeter that extends to and exposes a grounding plane 1000 (Ref. to Fig. 10). The grounding plane 1000, however could be any reference plane fixed at a given potential level. For the embodiment shown in Fig. 10 the reference plane potential level is fixed at ground. Also note that the ground potential level could be a TTL Logic ground or some other signal ground, chassis ground or some other reference ground. The trench perimeter is preferably a continuous trench. The interior walls 1002 of the elongated through holes and the edges 1004 about the mouth of the holes are then plated with a continuous layer of conductive material 1006 there through thereby providing a path to ground. The structure of the guard trench comprises a micro-milled trench that is plated there through 902. The plating of the trench is continuous along the interior wall 1002 of the trench an extending to the ground plane 1000. The plating wraps around the rim of the opening of the trench and laterally extends from the opening along the edge 1004 about the mouth or opening of the trench forming a lip 1008. The ground plane 1000 and the plating over the interior wall 1002 and the plating lip 1008 form a partial coaxial outer shield about the EMC sensitive inner conductor track 904 thereby creating a coaxial shielding structure.

Referring to Fig. 11 and Fig. 12, double guard trenching 1200 with a coaxialised EMC sensitive track is shown. This is a variation of the above-described guard trenching. This embodiment comprises an inner 1100 and outer 1102 trenched via with a coaxialised EMC sensitive track 1104 (circuit trace) there between. The trace is shown as segmented because it is hidden from view; however, the trace is actually continuous. This embodiment can be exactly the same as the single guard trenching described above with the exception of having the inner trench for further shielding and to completely surrounding the EMC sensitive track. The double guard trenching provides a continuous and complete outer shield surrounding the EMC sensitive track because of the joining lip structure 1201 of the double trenches.

## Claims

1. A printed circuit board having a wiring connection structure for interconnecting wiring circuit traces on a plurality of circuit trace layers applied on a plurality of printed circuit board layers and electrically isolated there between by the printed circuit board layers and having a printed circuit board multi-layer structure, **characterized by**:
a hollow through hole (102) having a non-circular shaped transverse cross section and having an interior wall that vertically extends through and intersects and exposes at least a first wire circuit trace and a second wire circuit trace and having a plating of conductive material applied to the interior wall electrically connecting the first and second wire circuit traces.

2. The printed circuit board of claim 1, wherein the non-circular shaped transverse cross section of the hollow through hole is "U" shaped.

3. The printed circuit board of claim 1, wherein the non-circular shaped transverse cross section of the hollow through hole is "L" shaped.

4. The printed circuit board of claim 1, wherein the non-circular shaped transverse cross section of the hollow through hole is cross-shaped.

5. The printed circuit board of claim 1, wherein the non-circular shaped transverse cross section of the hollow through hole has a non-circular continuously curved shape.

6. The printed circuit board of claim 1 wherein the non-circular shaped transverse cross section of the hollow through hole is square shaped.

7. The printed circuit board of claim 1 wherein the non-circular shaped transverse cross section of the hollow through hole is rectangle shaped.

8. The printed circuit board of claim 1 wherein the non-circular shaped transverse cross section of the hollow through hole is double cross shaped.

9. The printed circuit board of claim 1 wherein the non-circular shaped transverse cross section of the hollow through hole is star shaped.

10. The printed circuit board of claim 1 wherein the non-circular shaped transverse cross section of the hollow through hole is oval shaped.

11. The printed circuit board of claim 1 wherein the non-circular shaped transverse cross section of the hollow through hole is irregularly shaped.

12. The printed circuit board of any one of claims 1-11 **characterized by**: the non-circular shaped transverse cross section of the hollow through hole having a major diameter (706, 712) and a minor diameter (704, 710) less than the major diameter, and wherein the minor diameter is less than a width of the first wire circuit trace.

13. The printed circuit board of claim 12 wherein the major diameter (706) is at least twice the minor diameter (704).

14. The printed circuit board of claim 12 wherein the major diameter (712) is at least three times the minor diameter (710).

15. The printed circuit board of any one of claims 1-14 **characterized by**: a first through hole, a second through hole, and a third through hole, each having the non-circular shaped transverse cross section, and wherein the first through hole is in the first wire circuit trace, the second through hole is in an insulation layer between the first wire circuit trace and the second wire circuit trace, and the third though hole is in the second wire circuit trace, and wherein the first, second and third through holes are vertically aligned and plated with the conductive plating material to form the hollow through hole which extends from and electrically connects the first wire circuit trace with the second wire circuit trace.

16. The printed circuit board of any one of claims 1-15 **characterized by**: at least a second hollow through hole (708) having an interior wall plated with a conductive material and having a non-circular shaped transverse cross section which is different from the non-circular shaped transverse cross section of the first hollow through hole (702).

17. A method of interconnecting at least two wire circuit traces applied on a plurality of printed circuit board layers **characterized by** the steps of:
applying at least a first wire circuit trace to a main surface of a first printed circuit board layer wherein said first wire circuit trace has a first terminal landing pad;
forming an insulation layer over said first wire circuit trace;
applying at least a second wire circuit trace over the insulation layer, said second wire circuit trace having a second terminal landing pad vertically aligned over the first terminal landing pad;
cutting through the first terminal landing pad, the insulation layer, and the second terminal landing pad forming a hollow through hole (102) there through, the hollow through hole having a non-circular shaped transverse cross section and an interior wall; and
plating the interior wall of the hollow through hole (102) with an electrically conductive material thereby electrically connecting the first wire circuit trace and the second wire circuit trace by the connection established between the first terminal landing pad and
second terminal landing pad.

18. The method of interconnecting a plurality of wire traces of claim 17, wherein in the cutting step, the cutting is by plasma ablation.

19. The method of interconnecting a plurality of wire traces of claim 17, wherein in the cutting step, the cutting is by laser processing.

20. The method of any one of claims 17-19 wherein the non-circular shaped transverse cross-section of the hollow through hole has a shape of a "U."

21. The method of any one of claims 17-19 wherein the non-circular shaped transverse cross-section of the hollow through hole has a shape of a "L."

22. The method of any one of claims 17-19 wherein the non-circular shaped transverse cross-section of the hollow through hole has a shape of a "cross."

23. The method of any one of claims 17-19 wherein the non-circular shaped transverse cross-section of the hollow through hole has a shape of a "non-circular continuous curve."

24. The method of any one of claims 17-19 wherein the non-circular shaped transverse cross-section of the hollow through hole has a shape of a "square."

25. The method of any one of claims 17-19 wherein the non-circular shaped transverse cross-section of the hollow through hole has a shape of a "rectangle."

26. The method of any one of claims 17-19 wherein the non-circular shaped transverse cross-section of the hollow through hole has a shape of a "double cross."

27. The method of any one of claims 17-19 wherein the non-circular shaped transverse cross-section of the hollow through hole has a shape of a "star."

28. The method of any one of claims 17-19 wherein the non-circular shaped transverse cross-section of the hollow through hole has a shape of a "oval."

29. The method of any one of claims 17-19 wherein the non-circular shaped transverse cross-section of the hollow through hole has a shape of a "an irregular shape."

30. The method of any one of claims 17-29 **characterized by** cutting at least a second hollow through hole (708) in the printed circuit board and plating an interior wall thereof with a conductive material.

## Patentansprüche

1. Leiterplatte, die über eine Verdrahtungsstruktur zum Zusammenschalten von Verdrahtungsbahnen auf einer Vielzahl von Leiterbahnschichten, die auf einer Vielzahl von Leiterplattenschichten aufgebracht und dort dazwischen durch die Leiterplattenschichten galvanisch getrennt sind, sowie über eine Leiterplatten-Mehrschichtenstruktur verfügt, **gekennzeichnet durch**:
ein ausgespartes Durchgangsloch (102) mit einem nichtzirkulären transversalen Querschnitt und einer Innenwand, die mindestens eine erste Verdrahtungsbahn und eine zweite Verdrahtungsbahn freilegt, sich vertikal **durch** diese hindurch erstreckt und diese schneidet, sowie einer auf die Innenwand aufgebrachten Plattierung aus leitfähigem Material, welche die erste und die zweite Verdrahtungsbahn elektrisch miteinander verbindet.

2. Leiterplatte nach Anspruch 1, wobei der nichtzirkuläre transversale Querschnitt des ausgesparten Durchgangslochs U-förmig ist.

3. Leiterplatte nach Anspruch 1, wobei der nichtzirkuläre transversale Querschnitt des ausgesparten Durchgangslochs L-förmig ist.

4. Leiterplatte nach Anspruch 1, wobei der nichtzirkuläre transversale Querschnitt des ausgesparten Durchgangslochs kreuzförmig ist.

5. Leiterplatte nach Anspruch 1, wobei der nichtzirkuläre transversale Querschnitt des ausgesparten Durchgangslochs von nichtzirkulärer, durchgängig gekrümmter Gestalt ist.

6. Leiterplatte nach Anspruch 1, wobei der nichtzirkuläre transversale Querschnitt des ausgesparten Durchgangslochs quadratisch ist.

7. Leiterplatte nach Anspruch 1, wobei der nichtzirkuläre transversale Querschnitt des ausgesparten Durchgangslochs rechteckig ist.

8. Leiterplatte nach Anspruch 1, wobei der nichtzirkuläre transversale Querschnitt des ausgesparten Durchgangslochs doppelkreuzförmig ist.

9. Leiterplatte nach Anspruch 1, wobei der nichtzirkuläre transversale Querschnitt des ausgesparten Durchgangslochs sternförmig ist.

10. Leiterplatte nach Anspruch 1, wobei der nichtzirkuläre transversale Querschnitt des ausgesparten Durchgangslochs oval ist.

11. Leiterplatte nach Anspruch 1, **dadurch gekennzeichnet, dass** der nichtzirkuläre transversale Querschnitt des ausgesparten Durchgangslochs unregelmäßig geformt ist.

12. Leiterplatte nach einem der Ansprüche 1-11, **dadurch gekennzeichnet, dass**:
der nichtzirkuläre transversale Querschnitt des ausgesparten Durchgangslochs einen primären Durchmesser (706, 712) und einen sekundären Durchmesser (704, 710) hat, der kleiner als der primäre Durchmesser ist, und wobei der sekundäre Durchmesser kleiner als eine Breite der ersten Verdrahtungsbahn ist.

13. Leiterplatte nach Anspruch 12, wobei der primäre Durchmesser (706) mindestens zweimal so groß ist wie der sekundäre Durchmesser (704).

14. Leiterplatte nach Anspruch 12, wobei der primäre Durchmesser (712) mindestens dreimal so groß ist wie der sekundäre Durchmesser (710).

15. Leiterplatte nach einem der Ansprüche 1-14, **gekennzeichnet durch**:
ein erstes Durchgangsloch, ein zweites Durchgangsloch und ein drittes Durchgangsloch, wovon jedes über einen nichtzirkulären transversalen Querschnitt verfügt, und wobei sich das erste Durchgangsloch in der ersten Verdrahtungsbahn befindet, das zweite Durchgangsloch in einer Isolierungsschicht zwischen der ersten Verdrahtungsbahn und
der zweiten Verdrahtungsbahn und das dritte Durchgangsloch in der zweiten Verdrahtungsbahn liegt, und wobei das erste, das zweite und das dritte Durchgangsloch vertikal angeordnet und mit dem leitfähigen Überzugsmaterial plattiert sind, um das ausgesparte Durchgangsloch zu bilden, welches sich von der ersten Verdrahtungsbahn erstreckt und diese mit der zweiten Verdrahtungsbahn elektrisch verbindet.

16. Leiterplatte nach einem der Ansprüche 1-15, **gekennzeichnet durch**:
mindestens ein zweites ausgespartes Durchgangsloch (708) mit einer mit einem leitfähigen Material plattierten Innenwand und einem nichtzirkulären transversalen Querschnitt, der sich vom nichtzirkulären transversalen Querschnitt des ersten ausgesparten Durchgangslochs (702) unterscheidet.

17. Verfahren des Zusammenschaltens von mindestens zwei aus einer Vielzahl von Leiterplattenschichten aufgebrachten Verdrahtungsbahnen, durch die folgenden Schritte gekennzeichnet**:**
Aufbringen von mindestens einer ersten Verdrahtungsbahn auf eine Hauptfläche einer ersten Leiterplattenschicht, wobei die erste Verdrahtungsbahn über eine erste Kontaktstelle verfügt;
Bilden einer Isolierungsschicht über der ersten Verdrahtungsbahn;
Aufbringen von mindestens einer zweiten Verdrahtungsbahn über die Isolierungsschicht, wobei die zweite Verdrahtungsbahn über eine zweite Kontaktstelle verfügt, die vertikal über der ersten Kontaktstelle angeordnet ist;
Hindurchschneiden durch die erste Kontaktstelle, die Isolierungsschicht und die zweite Kontaktstelle, wobei sich ein ausgespartes Durchgangsloch (102) durch dieselben bildet und das ausgesparte Durchgangsloch über einen nichtzirkulären transversalen Querschnitt und eine Innenwand verfügt;
und
Plattieren der Innenwand des ausgesparten Durchgangslochs (102) mit einem elektrisch leitfähigen Material, wodurch die erste Verdrahtungsbahn und die zweite Verdrahtungsbahn durch die zwischen der ersten Kontaktstelle und der zweiten Kontaktstelle hergestellte Verbindung elektrisch miteinander verbunden werden.

18. Verfahren zum Zusammenschalten einer Vielzahl von Leiterbahnen nach Anspruch 17, wobei das Schneiden im Schneidvorgang mittels Plasmaablation erfolgt.

19. Verfahren zum Zusammenschalten einer Vielzahl von Leiterbahnen nach Anspruch 17, wobei das Schneiden im Schneidvorgang mittels Laserbearbeitung erfolgt.

20. Verfahren nach einem der Ansprüche 17-19, wobei der nichtzirkuläre transversale Querschnitt des ausgesparten Durchgangslochs U-förmig ist.

21. Verfahren nach einem der Ansprüche 17-19, wobei der nichtzirkuläre transversale Querschnitt des ausgesparten Durchgangslochs L-förmig ist.

22. Verfahren nach einem der Ansprüche 17-19, wobei der nichtzirkuläre transversale Querschnitt des ausgesparten Durchgangslochs kreuzförmig ist.

23. Verfahren nach einem der Ansprüche 17-19, wobei der nichtzirkuläre transversale Querschnitt des ausgesparten Durchgangslochs von der Gestalt einer nichtzirkulären durchgängigen Krümmung ist.

24. Verfahren nach einem der Ansprüche 17-19, wobei der nichtzirkuläre transversale Querschnitt des ausgesparten Durchgangslochs quadratisch ist.

25. Verfahren nach einem der Ansprüche 17-19, wobei der nichtzirkuläre transversale Querschnitt des ausgesparten Durchgangslochs rechteckig ist.

26. Verfahren nach einem der Ansprüche 17-19, wobei der nichtzirkuläre transversale Querschnitt des ausgesparten Durchgangslochs doppelkreuzförmig ist.

27. Verfahren nach einem der Ansprüche 17-19, wobei der nichtzirkuläre transversale Querschnitt des ausgesparten Durchgangslochs sternförmig ist.

28. Verfahren nach einem der Ansprüche 17-19, wobei der nichtzirkuläre transversale Querschnitt des ausgesparten Durchgangslochs oval ist.

29. Verfahren nach einem der Ansprüche 17-19, **dadurch gekennzeichnet, dass** der nichtzirkuläre transversale Querschnitt des ausgesparten Durchgangslochs unregelmäßig geformt ist.

30. Verfahren nach einem der Ansprüche 17-29, **gekennzeichnet durch** das Schneiden von mindestens einem zweiten ausgesparten Durchgangsloch (708) in der Leiterplatte und Plattieren einer Innenwand desselben mit einem leitfähigen Material.

## Revendications

1. Carte de circuit imprimé comportant une structure de connexion de câblage pour interconnecter des pistes de circuit de câblage sur une pluralité de couches de piste de circuit qui sont appliquées sur une pluralité de couches de carte de circuit imprimé et qui sont isolées électriquement entre elles au moyen des couches de carte de circuit imprimé et comportant une structure multicouche de carte de circuit imprimé, **caractérisée par**:
un trou traversant creux (102) présentant une section en coupe transversale de forme non circulaire et comportant une paroi intérieure qui s'étend verticalement au travers et qui intersecte et expose au moins une première piste de circuit de câblage et une seconde piste de circuit de câblage et comportant un plaquage de matériau conducteur qui est appliqué sur la paroi intérieure en connectant électriquement les première et seconde piste de circuits de câblage.

2. Carte de circuit imprimé selon la revendication 1, dans laquelle la section en coupe transversale de forme non circulaire du trou traversant creux est en forme de "U".

3. Carte de circuit imprimé selon la revendication 1, dans laquelle la section en coupe transversale de forme non circulaire du trou traversant creux est en forme de "L".

4. Carte de circuit imprimé selon la revendication 1, dans laquelle la section en coupe transversale de forme non circulaire du trou traversant creux est en forme de croix.

5. Carte de circuit imprimé selon la revendication 1, dans laquelle la section en coupe transversale de forme non circulaire du trou traversant creux présente une forme courbe en continu non circulaire.

6. Carte de circuit imprimé selon la revendication 1, dans laquelle la section en coupe transversale de forme non circulaire du trou traversant creux est de forme carrée.

7. Carte de circuit imprimé selon la revendication 1, dans laquelle la section en coupe transversale de forme non circulaire du trou traversant creux est de forme rectangulaire.

8. Carte de circuit imprimé selon la revendication 1, dans laquelle la section en coupe transversale de forme non circulaire du trou traversant creux est en forme de double croix.

9. Carte de circuit imprimé selon la revendication 1, dans laquelle la section en coupe transversale de forme non circulaire du trou traversant creux est en forme d'étoile.

10. Carte de circuit imprimé selon la revendication 1, dans laquelle la section en coupe transversale de forme non circulaire du trou traversant creux est de forme ovale.

11. Carte de circuit imprimé selon la revendication 1, dans laquelle la section en coupe transversale de forme non circulaire du trou traversant creux est de forme irrégulière.

12. Carte de circuit imprimé selon l'une quelconque des revendications 1 à 11, **caractérisée en ce que** la section en coupe transversale de forme non circulaire du trou traversant creux présente un diamètre principal (706, 712) et un diamètre secondaire (704, 710) inférieur au diamètre principal et dans laquelle le diamètre secondaire est inférieure à une largeur de la première piste de circuit de câblage.

13. Carte de circuit imprimé selon la revendication 12, dans laquelle le diamètre principal (706) est au moins le double du diamètre secondaire (704).

14. Carte de circuit imprimé selon la revendication 12, dans laquelle le diamètre principal (712) est au moins le triple du diamètre secondaire (710).

15. Carte de circuit imprimé selon l'une quelconque des revendications 1 à 14, **caractérisée par**: un premier trou traversant, un second trou traversant et un troisième trou traversant dont chacun présente la section en coupe transversale de forme non circulaire et dans laquelle le premier trou traversant est dans la première piste de circuit de câblage, le second trou traversant est dans une couche d'isolation entre la première piste de circuit de câblage et la seconde piste de circuit de câblage et le troisième trou traversant est dans la seconde piste de circuit de câblage et dans laquelle les premier, second et troisième trous traversants sont alignés verticalement et sont plaqués à l'aide du matériau de plaquage conducteur de manière à former le trou traversant creux qui s'étend depuis la première piste de circuit de câblage et qui connecte électriquement cette première piste de circuit de câblage avec la seconde piste de circuit de câblage.

16. Carte de circuit imprimé selon l'une quelconque des revendications 1 à 15, **caractérisée par**: au moins un second trou traversant creux (708) qui comporte une paroi intérieure qui est plaquée à l'aide d'un matériau conducteur et qui présente une section en coupe transversale de forme non circulaire qui est différente de la section en coupe transversale de forme non circulaire du premier trou traversant creux (702).

17. Procédé d'interconnexion d'au moins deux pistes de circuit de câblage qui sont appliquées sur une pluralité de couches de carte de circuit imprimé, **caractérisé par** les étapes de:
application d'au moins une première piste de circuit de câblage sur une surface principale d'une première couche de carte de circuit imprimé, où ladite première piste de circuit de câblage comporte une première plage de connexion de borne;
formation d'une couche isolante au-dessus de ladite première piste de circuit de câblage;
application d'au moins une seconde piste de circuit de câblage sur la couche isolante, ladite seconde piste de circuit de câblage comportant une seconde plage de connexion de borne alignée verticalement au-dessus de la première plage de connexion de borne;
découpe au travers de la première plage de connexion de borne, de la couche isolante et de la seconde plage de connexion de borne en formant un trou traversant creux (102) au travers, le trou traversant creux présentant une section en coupe transversale de forme non circulaire et une paroi intérieure; et
plaquage de la paroi intérieure du trou traversant creux (102) avec un matériau électriquement conducteur, d'où la connexion électrique de la première piste de circuit de câblage et de la seconde piste de circuit de câblage au moyen de la connexion qui est établie entre la première plage de connexion de borne et la seconde plage de connexion de borne.

18. Procédé d'interconnexion d'une pluralité de pistes de câblage selon la revendication 17, dans lequel, au niveau de l'étape de découpe, la découpe est au moyen d'une ablation plasma.

19. Procédé d'interconnexion d'une pluralité de pistes de câblage selon la revendication 17, dans lequel, au niveau de l'étape de découpe, la découpe est au moyen d'un traitement laser.

20. Procédé selon l'une quelconque des revendications 17 à 19, dans lequel la section en coupe transversale de forme non circulaire du trou traversant creux présente une forme de "U".

21. Procédé selon l'une quelconque des revendications 17 à 19, dans lequel la section en coupe transversale de forme non circulaire du trou traversant creux présente une forme de "L".

22. Procédé selon l'une quelconque des revendications 17 à 19, dans lequel la section en coupe transversale de forme non circulaire du trou traversant creux présente une forme de "croix".

23. Procédé selon l'une quelconque des revendications 17 à 19, dans lequel la section en coupe transversale de forme non circulaire du trou traversant creux présente une forme de "courbe continue non circulaire".

24. Procédé selon l'une quelconque des revendications 17 à 19, dans lequel la section en coupe transversale de forme non circulaire du trou traversant creux présente une forme de "carré".

25. Procédé selon l'une quelconque des revendications 17 à 19, dans lequel la section en coupe transversale de forme non circulaire du trou traversant creux présente une forme de "rectangle".

26. Procédé selon l'une quelconque des revendications 17 à 19, dans lequel la section en coupe transversale de forme non circulaire du trou traversant creux présente une forme de "double croix".

27. Procédé selon l'une quelconque des revendications 17 à 19, dans lequel la section en coupe transversale de forme non circulaire du trou traversant creux présente une forme d'"étoile".

28. Procédé selon l'une quelconque des revendications 17 à 19, dans lequel la section en coupe transversale de forme non circulaire du trou traversant creux présente une forme de "ovale".

29. Procédé selon l'une quelconque des revendications 17 à 19, dans lequel la section en coupe transversale de forme non circulaire du trou traversant creux présente une forme "irrégulière".

30. Procédé selon l'une quelconque des revendications 17 à 29, **caractérisé par** la découpe d'au moins un second trou traversant creux (708) dans la carte de circuit imprimé et par le plaquage de sa paroi intérieure à l'aide d'un matériau conducteur.
